Europäisches Patentamt

European Patent Office

Office européen des brevets

(11) Publication number: **0 458 469 A1**

# EUROPEAN PATENT APPLICATION

(21) Application number: 91303786.7

(22) Date of filing: 26.04.91

(51) Int. Cl.5: **H01L 23/495, H01L 23/498**

(30) Priority: 24.05.90 JP 134354/90
19.10.90 JP 281083/90

(43) Date of publication of application:
**27.11.91 Bulletin 91/48**

(84) Designated Contracting States:
**DE FR GB**

(71) Applicant: NIPPON STEEL OORPORATION
6-3 Otemachi 2-chome Chiyoda-ku
Tokyo 100(JP)

(72) Inventor: **Ohno, Yasuhide, c/o Nippon Steel
Corporation**
**R & D Laboratories-I, 1618, Ida, Nakahara-ku
Kawasaki-shi, Kanagawa(JP)**
Inventor: **Ohzeki, Yoshio, c/o Nippon Steel
Corporation**
**R & D Laboratories-I, 1618, Ida, Nakahara-ku
Kawasaki-shi, Kanagawa(JP)**

(74) Representative: **Arthur, Bryan Edward et al
Withers & Rogers 4 Dyer's Buildings Holborn
London EC1N 2JT(GB)**

(54) Composite lead frame and semiconductor device using the same.

(57) A composite lead frame comprising a lead frame (10), leads (28) supported on a plastic film (22') having a device hole (24), and a metal pad (14, 32) for mounting a semiconductor chip (34) is disclosed. The lead frame (10) has a plurality of inner lead portions (12) each of which is bonded to each of the leads (28), respectively. The metal pad (14, 32) also supports the leads (28) through the plastic film (22'). The metal pad (14, 32) may be bonded to the lead frame (10) through an adhesive tape (16), or may be integrated with the lead frame (10). Bonding wires (36) to connect the leads (28) and the semiconductor chip (34) can be easily and securely bonded to the leads (28) in virtue of the metal pad (14, 32) supporting the leads (28). Additionally, a semiconductor device incorporating the composite lead frame has efficient heat dissipation and reliability by virtue of the metal pad.

*Fig. 2*

## 1. Field of the Invention

The present invention relates to a composite lead frame used in the manufacturing of packaged semiconductor devices in the semiconductor electronic industry, and a semiconductor device using the composite lead frame.

## 2. Description of the Related Art

Recently, as the scale of integration of semiconductor devices has been increased and their functions have become more complex, the number of pins of a package has been increased, and therefore, lead frames having a higher dimensional accuracy and finer pitch have been required. Particularly, these features are intensively required in ASIC (Application Specific Integrated Circuit) devices.

A press working method or an etching method is employed to make the lead frame at the present time. In the etching method, lead frames having a finer pitch can be made than in the press working method, but the etching method entails manufacturing costs which are several times as much as the press working method. The lower limit of the width of a lead that can be made with the etching method is reportedly seventy to eighty percent of the thickness of the lead. Therefore, a thinner plate must be used to make a lead frame having a finer pitch. However, a thinner plate does not have sufficient strength, so that negative effects such as bending of leads occur in handling or bonding, etc. of the packaged semiconductor device. The limit of thickness is 0.1 to 0.15 mm and the limit of the number of pins is about 200.

On the other hand, a TAB (Tape Automated Bonding) technique can be applied to provide a larger number of pins. In the TAB technique, however, the strength of the leads is low because they are made from a copper sheet. Therefore, many problems such as misalignment arise in external bonding, so that the bonding of the leads cannot be handled in the same manner as in the conventional lead frames.

As a lead frame which realizes the larger number of pins, a composite lead frame, comprising first lead members and second lead members arranged in the inside of the first lead members such that inner lead portions of the first lead members overlap the outer lead portions of the second lead members to be bonded to them, wherein the second lead members are formed with a semiconductor chip mounting part from a metal sheet on an insulating plastic film using a photoetching method, is disclosed in Japanese Unexamined Patent Publication (Kokai) No. 62-232948. Connections between the second lead members and the semiconductor chip mounted on the semiconductor chip mounting part are performed by wire bonding. Japanese Unexamined Patent Publication (Kokai) No. 2-22850 discloses a similar composite lead frame wherein all the second lead members are bonded to the semiconductor chip at the same time through bumps formed on the chip, as is done in the TAB technique.

However, these composite lead frames which have been proposed have the following shortcomings.

The former composite lead frame has a problem that heat dissipation is not sufficient where a chip having large heating value due to large scale of integration is mounted because the bottom layer of the composite lead frame under the chip is an insulating film having low thermal conductivity. Additionally, when bonding wires to connect the semiconductor chip to the second lead members are bonded on the second lead members, sufficient supersonic vibration for bonding is not obtained, because the second lead members are made of copper sheet and an insulating tape supporting the second lead members has low rigidity. Therefore, imperfect bonds are sometimes generated in wire bonding. Furthermore, when sealing with resin, connections between the first lead members and the second lead members tend to be damaged due to deformation of the second lead members because of their low rigidity.

The latter composite lead frame has many additional industrial problems so that a technique to form low-priced and uniform bumps on a chip has not yet been established.

## SUMMARY OF THE INVENTION

It is an object of the present invention to provide a composite lead frame wherein the aforementioned shortcomings are overcome, and a semiconductor device using the same can be produced.

In accordance with the present invention, there is provided a composite lead frame comprising a lead frame having a plurality of inner lead portions and leads supported on a film member having a device hole for accepting a semiconductor chip wherein each of the inner lead portions is bonded to each of the leads, respectively, characterized by further comprising a pad for mounting the semiconductor chip, wherein the pad is thermally coupled to the lead frame and supports the leads through the film member.

In accordance with the present invention there is also provided a semiconductor device comprising a semiconductor chip, a lead frame having a plurality of inner lead portions, leads supported on a film member having a device hole for accepting the semiconductor chip wherein each of the inner lead portions is bonded to each of the leads, respectively, and wherein the semiconductor chip is connected to the leads through bonding wires, and a resin for sealing the semiconductor chip, the leads, and bonded portions between the inner lead portions and the leads, characterized by further comprising a pad for mounting the semiconductor chip, wherein the pad is thermally coupled to the lead frame and supports the leads through the film member.

## BRIEF DESCRIPTION OF THE DRAWINGS

Figures 1A to 1E are diagrams for explaining a manufacturing process of a composite lead frame according to a first embodiment of the present invention;

Figure 2 is an A-A' cross-sectional view of the composite lead frame according to the first embodiment of the present invention;

Figures 3A to 3D are diagrams for explaining a manufacturing process of a composite lead frame according to a second embodiment of the present invention;

Figure 4 is a B-B' cross-sectional view of the composite lead frame according to the second embodiment of the present invention; and

Figure 5 is a cross-sectional view of a semiconductor device according to the present invention.

## DESCRIPTION OF THE PREFERRED EMBODIMENTS

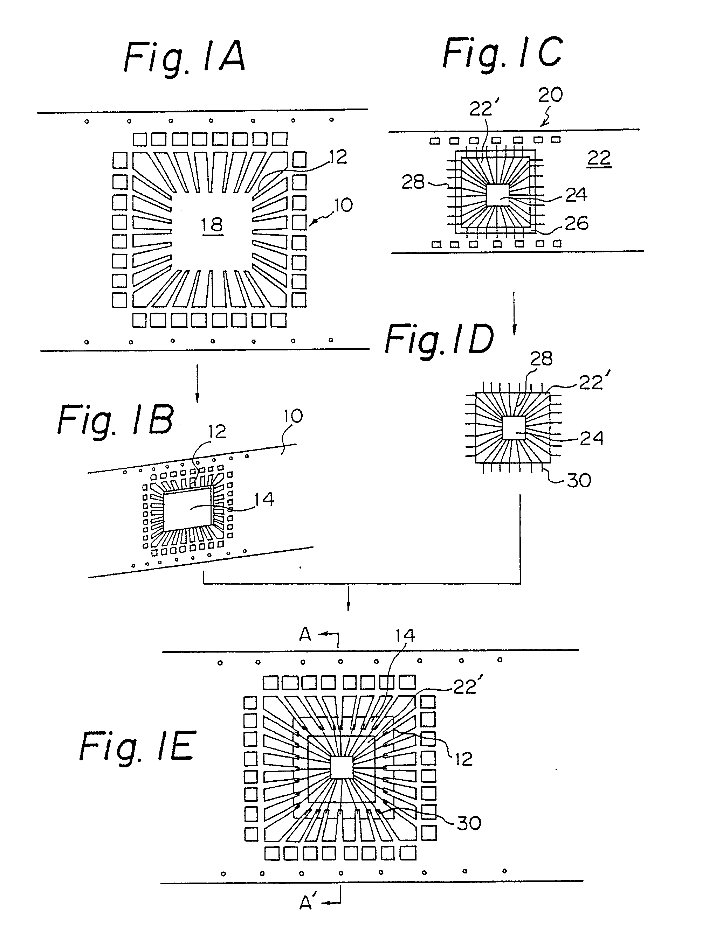

Figures 1A to 1E are diagrams for explaining a manufacturing process of a composite lead frame according to a first embodiment of the present invention.

Referring to Fig. 1A, a lead frame 10 having inner lead portions 12 is shown. The lead frame 10 can be manufactured from a metal sheet using, for example, a press working method to make conventional lead frames. As shown in Fig. 1B, a metal pad 14 is bonded to the lead frame 10 through an insulating adhesive tape 16 (not shown in this figure) so that the metal pad 14 covers a window 18 (Fig. 1A) of the lead frame 10.

Referring to Fig. 1C, a tape assembly 20 manufactured by using the TAB technique is shown. The tape assembly 20 comprises a plastic film 22 and 22' having a device hole 24 and an outer lead hole 26 formed by punching, etc., and a plurality of leads 28 formed by a photo-etching method, etc., according the TAB technique. Note that the leads 28 do not project onto the device hole 24, because connections between the leads 28 and a semiconductor chip are performed not through bumps on the semiconductor chip but through bonding wires.

The leads 28 and a portion of the plastic film 22' supporting the leads 28 are cut out from the tape assembly 20 at the outer lead hole 26, as shown in Figure 1D.

As shown in Figure 1E, the portion of the plastic film 22' is bonded to the metal pad 14 through the insulating adhesive tape 16 ( not shown in this figure) so that each of outer lead portions 30 of the leads 28 and each of inner lead portions 12 of the lead frame 10 is overlapped respectively, and they are bonded together by thermo-compression bonding, at the overlapping portion.

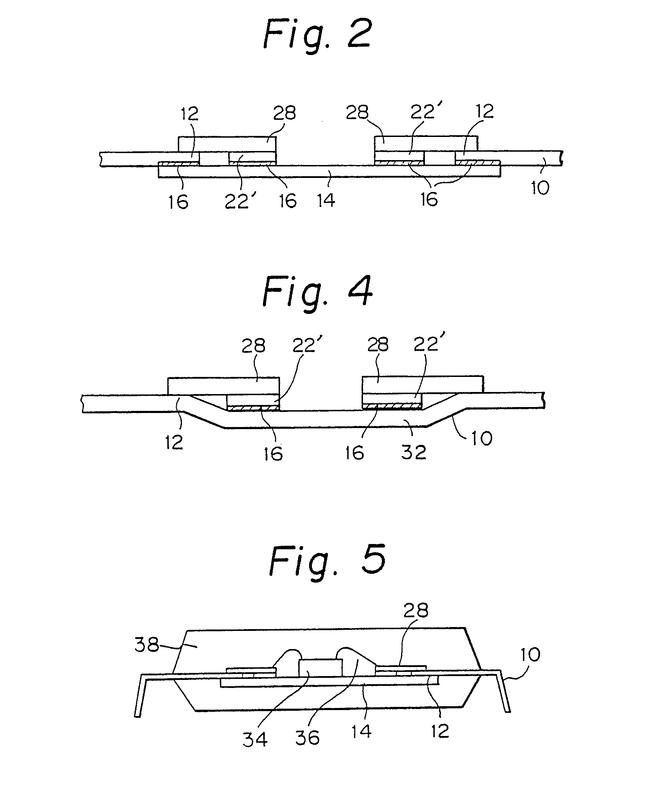

Figure 2 is a A-A' cross-sectional view of the composite lead frame according to the first embodiment of the present invention. In this figure, the aforementioned insulating adhesive tape 16 is bonded between the metal pad 14 and the inner lead portions 12 of the lead frame 10 and between the metal pad 14 and the plastic film 22'.

In external connection, a conventional bonding technique can be applied, since the same material as that of the conventional lead frames can be used for the lead frame 10. Additionally, since connection to the semiconductor chip is performed through the leads 28, width and pitch of the leads 12 of the lead frame 10 need not be narrow. Therefore, the conventional lead frames can be used for the devices having a larger number of pins.

Regarding the inner portion, the leads 28 can be finely processed using the TAB technique.

Furthermore, use of the metal pad 14 having efficient thermal conductivity and rigidity provides the following merit.

(a) Dissipation of heat generated in the semiconductor chip is more facilitated than with the sole use of the insulating film.

(b) Application of supersonic vibration is easier since the leads 28 are supported on the rigid metal pad 14 through the plastic film 22'. Therefore reliable bonding is performed by a conventional wire bonding machine.

(c) Since undesirable stress is not applied to junctions by virtue of the metal pad 14, damaging of connections is avoided, when resin sealing.

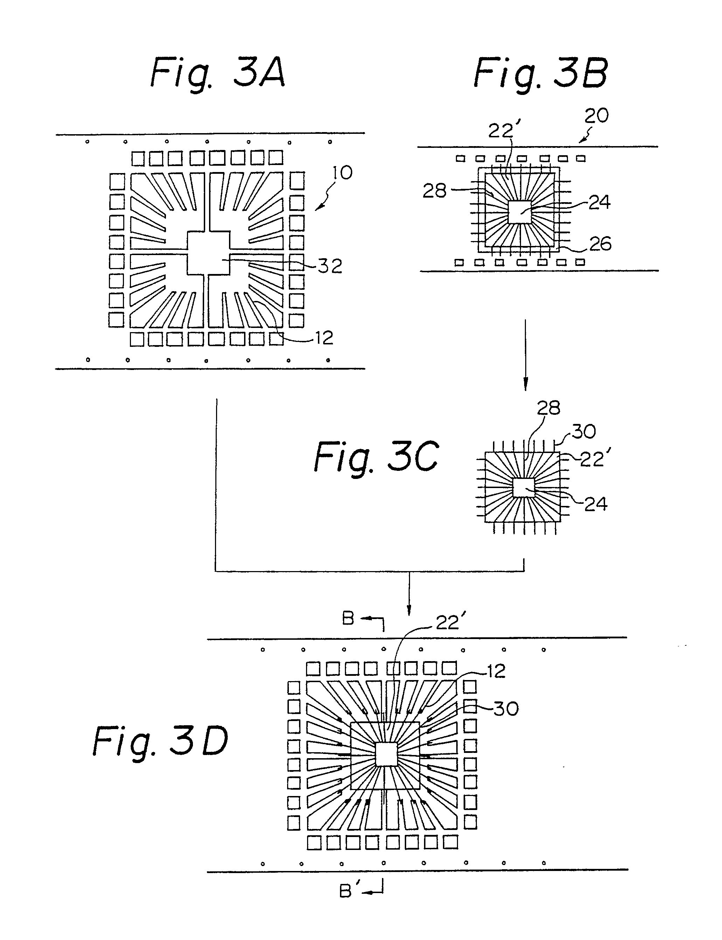

Figures 3A to 3D are diagrams for explaining a manufacturing process of a composite lead frame according to a second embodiment of the present invention, and Figure 4 is a B-B' cross-sectional view of the composite lead frame. The same reference numerals as used in Figs. 1A to 1E and 2 are used for constituents which are similar to those in Figs. 1A to 1E and 2, and thus descriptions thereof are left out.

As shown in Fig. 3A, a lead frame 10 has a pad portion 32 in a body. The pad portion 32 has a similar function to the metal pad 14 described with reference to Fig. 1B. In the second embodiment of the present invention, a merit similar to the first embodiment is obtained. Additionally, the composite lead frame is manufactured at lower cost because the pad portion 32 is integrated with the lead frame 10.

Figure 5 is a cross-sectional view of a semiconductor device using the composite lead frame described with reference to Figs. 1A to 1E and 2. A semiconductor chip 34 is mounted on the metal pad 14, and is connected to the leads 28 through bonding wires 36. Finally, the semiconductor chip 34 and the composite lead frame around the chip 34 are sealed with resin 38.

Example 1

A lead frame 10, as shown in Fig. 1A, having 350 pins, was made from a 0.15 mm thick plate of copper alloy. A pad 14 was made from the same material, and the lead frame 10 and the pad 14 were bonded with a tape 16. Leads 28 supported on a plastic film 22' having device hole 24 were made by using the TAB technique. Outer lead portions 30 of the leads 28 and inner lead portions 12 of the lead frame 10 were bonded together, to make a composite lead frame. The inner lead portions 12 were plated with silver at a thickness of 3.5 $\mu$m, the leads 28 were plated with gold, and they were bonded together by thermo-compression bonding.

A semiconductor chip was mounted on the composite lead frame and was connected to the leads 28 with gold bonding wires using a ball bonding technique. After a bonding strength test of the wire bonding, all connections were broken at "ball neck" portions (portions near the balls). This indicates that bonding strength at second bonding portions, i.e., bonding of the leads 28 and wires, is sufficient.

Example 2

A lead frame 10 having a pad portion 32 in a body, as shown in Fig. 4, having 350 pins, was made from a 0.15 mm thick plate of copper alloy. A composite lead frame was made by bonding the lead frame 10 and leads 28 supported on a plastic film 22' having device hole 24 made by using the TAB technique. The inner lead portions 12 was plated with silver at a thickness of 3.5 $\mu$m, the leads 28 were plated with gold, and they were bonded together by thermo-compression bonding.

After the same bonding strength test as Example 1, all connections were broken at ball neck portions.

Example 3

A semiconductor chip 34 was mounted on the composite lead frame as described in Example 1, the semiconductor chip 34 and leads 28 were connected with bonding wires 36, and they were sealed with resin 38, to make a semiconductor device having 350 pins, as shown in Fig. 5.

As a result of a temperature cycling test of the device repeated for 30 minutes at -55° C and 30 minutes at 150° C, the device was not deteriorated after 300 cycles.

Example 4

A lead frame having 216 pins was made from a 0.15 mm thick plate of Fe -42% nickel alloy. A pad for die bonding of a semiconductor chip was made from a 0.10 mm thick plate of copper alloy, and was bonded with the lead frame through an adhesive tape. Leads supported on a plastic film were made by using the TAB technique. A composite lead frame was made by bonding outer leads of the leads and inner leads of the lead frame in a process shown in Figs. 1A to 1E. The inner lead portions of the lead frame were plated with silver at a thickness of 3.5 $\mu$m thickness, the leads supported on the plastic film were plated with gold, and they were bonded together by thermo-compression bonding.

After the same bonding strength test as Example 1, all connections were broken at ball neck portions.

Example 5

A lead frame having a pad in a body for mounting a semiconductor chip having 360 pins was made from a 0.125 mm thick plate of Fe -42% nickel alloy. A composite lead frame was made by bonding the lead frame and leads supported on a plastic film having a device hole made by using the TAB technique, in a process shown in Figs. 3A to 3D. The inner lead portion of the lead frame was plated with tin at a thickness of 2.8 $\mu$m, the leads supported on the film were plated with gold, and they were bonded together by thermo-compression bonding.

Example 6

A semiconductor chip was mounted on the pad of the lead frame of Example 5, the semiconductor chip was connected to the inner lead of the leads through bonding wires, and they were sealed with resin, to make a semiconductor device having 360 pins.

As a result of a temperature cycling test for the device repeated for 30 minutes at -55° C and 30 minutes at 150° C, the device was not deteriorated after 300 cycles.

Comparative Example

A composite lead frame was made from a lead frame and a copper sheet pattern supported on a plastic film. The lead frame is the same as that used in Example 1. The copper sheet pattern has a plurality of leads to be bonded with the lead frame and an island portion for mounting a semiconductor chip, as disclosed in Japanese Unexamined Patent Publication No. 62-232948. A semiconductor chip was die bonded on the island portion, and wire bonding was carried out under the same conditions as Example 3. Also, a semiconductor device for comparison was made by sealing with resin.

As a result of a bonding strength test of the wire bonding, a second bonding was found to be broken away at 6.5% of leads.

Next, a comparative test of this semiconductor device with the device of Example 3 was conducted.

A semiconductor chip which is uniformly exothermic in operation was mounted. The result of measurement of surface temperature of the devices two hours after initiation of operation was 78°C in the comparative device, and 47°C in the device according to the present invention, which shows efficient heat dissipation.

Additionally, the percentage of defective comparative devices in the temperature cycling test repeated for 30 minutes at -55°C and 30 minutes at 150°C, was 0.04% after 300 cycles.

## Claims

1. A composite lead frame comprising:
a lead frame (10) having a plurality of inner lead portions (12) and
leads (28) supported on a film member (22') having a device hole (24) for accepting a semiconductor chip (34) wherein each of the inner lead portions (12) is bonded to each of the leads (28), respectively, characterized by further comprising
a pad (14, 32) for mounting the semiconductor chip (34), wherein the pad (14, 32) is thermally coupled to the lead frame (10) and supports the leads (28) through the film member (22').

2. A composite lead frame as claimed in claim 1, wherein the pad (14) is bonded to the lead frame (10) through an adhesive tape (16).

3. A composite lead frame as claimed in claim 1, wherein the pad (32) is integrated with the lead frame (10).

4. A composite lead frame as claimed in claim 1, 2 or 3, wherein the pad (14, 32) is a metal pad.

5. A composite lead frame as claimed in claim 1, 2, 3 or 4, wherein the leads (28) supported on the film member (22') having a device hole (24) are made by using a tape automated bonding technique.

6. A semiconductor device comprising:
a semiconductor chip (34),
a lead frame (16) having a plurality of inner lead portions (12),
leads (28) supported on a film member (22') having a device hole (24) for accepting the semiconductor chip (34) wherein each of the inner lead portions (12) is bonded to each of the leads (28), respectively, and wherein the semiconductor chip (34) is connected to the leads (28) through bonding wires (36), and
a resin (38) for sealing the semiconductor chip (34), the leads (28), and bonded portions between the inner lead portions (12) and the leads (28), characterized by further comprising
a pad (14, 32) for mounting the semiconductor chip (34), wherein the pad (14, 32) is thermally coupled to the lead frame (10) and supports the leads (28) through the film member (22').

7. A semiconductor device as claimed in claim 6, wherein the pad (14) is bonded to the lead frame (10) through an adhesive tape (16).

8. A semiconductor device as claimed in claim 6, wherein the pad (32) is integrated with the lead frame (10).

9. A semiconductor device as claimed in claim 6, 7 or 8, wherein the pad (14, 32) is a metal pad.

10. A semiconductor device as claimed in claim 6, 7, 8 or 9, wherein the leads (28) supported on the film member (22') having a device hole (24) are made by using a tape automated bonding technique.

# Fig. 1A

# Fig. 1C

# Fig. 1B

# Fig. 1D

# Fig. 1E

# Fig. 2

# Fig. 4

# Fig. 5

7

# Fig. 3A

# Fig. 3B

# Fig. 3C

# Fig. 3D

8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | EP-A-0 247 775 (AMERICAN TELEPHONE & TELEGRAPH COMPANY) * column 3, line 3 - column 5, line 33 * * column 6, lines 5 - 17; figures 1-3, 5 * * ditto * | 1,3-6, 8-10,2,4 | H 01 L 23/495 H 01 L 23/498 |
| X | EP-A-0 247 644 (MONOLITHIC MEMORIES) * page 4, line 13 - page 6, line 27; figures 1, 2 * | 1,3,4,6,8, 9 | |
| X | PATENT ABSTRACTS OF JAPAN vol. 7, no. 214 (E-199)(1359) 21 September 1983, & JP-A-58 107659 (SEIKOO KEIYOU KOGYO) 27 June 1983, * the whole document * | 1,3,4,6,8, 9 | |
| Y | PROCEEDINGS OF THE IEEE/CHMT 1989 ELECTRONIC MANUFACTURING TECHNOLOGY SYMPOSIUM 1989, NEW YORK , US pages 221 - 229; D.Mallik et al.: "Multi-layer molded plastic package" * page 223, paragraph 1; figure 4 * | 2,4 | |

TECHNICAL FIELDS SEARCHED (Int. Cl.5)

H 01 L

The present search report has been drawn up for all claims

| Place of search | Date of completion of search | Examiner |
|---|---|---|
| Berlin | 19 August 91 | LE MINH I |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document